# NEW EUROPEAN PATENT SPECIFICATION

(11) **EP 0 921 418 B2**
(45) Date of publication and mention of the opposition decision: **22.10.2008**
(45) Mention of the grant of the patent: 30.06.2004
(21) Application number: 98309879.9
(22) Date of filing: 02.12.1998
(51) Int. Cl.: G02B 5/18, G02B 27/00

(54) **Diffractive optical element and optical system having the same**
Beugungselement und damit ausgestattetes optisches System
Elément optique diffractif et système optique l'utilisant

(30) Priority: 03.12.1997 JP 34858997; 03.12.1997 JP 34859097; 16.12.1997 JP 36341297; 01.12.1998 JP 35694198
(43) Date of publication of application: 09.06.1999
(73) Proprietor: CANON KABUSHIKI KAISHA, Tokyo (JP)
(72) Inventor: Kato, Hideo, Ohta-ku, Tokyo (JP); Maehara, Hiroshi, Ohta-ku, Tokyo (JP); Tamamori, Kenji, Ohta-ku, Tokyo (JP)
(74) Representative: TBK-Patent

(56) References cited:
- EP-A- 0 349 144
- EP-A- 0 422 611
- GB-A- 2 139 781
- JP-A- 6 324 262
- US-A- 4 780 175
- US-A- 5 257 132
- US-A- 5 667 700
- PATENT ABSTRACTS OF JAPAN vol. 012, no. 253 (P-731), 16 July 1988 & JP 63 043101 A (TOYO COMMUN EQUIP CO LTD), 24 February 1988

## Description

### FIELD OF THE INVENTION AND RELATED ART

This invention relates to a diffractive optical element and an optical system having the same. More particularly, the invention is concerned with a diffractive optical element of good durability and small change in shape with time, thus providing diffractive light in particular direction with high diffraction efficiency. The present invention is particularly suitable for an optical system in a device manufacturing exposure apparatus, for example, having a light source of ArF excimer laser or KrF excimer laser, for example.

Chromatic aberration of an optical system can be reduced by using a physical phenomenon that, if a diffractive optical element having a light diffracting function is provided on a lens surface or in a portion of the optical system, then, with respect to light rays of a certain reference wavelength, the chromatic aberration is produced inversely ("SPIE Vol.1354, International Lens Design Conference (1990)", Japanese Laid-Open Patent Applications, Laid-Open Nos. 4-213421 and 6-324262, U.S. Patent No. 5,044,706, etc.).

Generally, in such diffractive optical element, a diffraction grating having periodic structure is formed rotationally symmetrically with respect to a certain axis such as an optical axis, and the period pitch of the diffraction grating is gradually changed. The ring zone structure having such periodic structure produces diffraction function which serves as a lens.

Such diffractive optical element provides good correction effect particularly to chromatic aberration which is produced at a refractive surface due to dispersion of glass. By changing the period of the periodic structure, an effect of aspherical surface lens can be provided. Thus, it is very effective for aberration reduction.

A specific structure of a diffractive optical element that produces such diffraction function is called "Kinoform". Examples are: one with portions for producing a phase difference 2π and being made continuous; one with binary shape (stepping shape) wherein continuous phase difference distribution is approximated by a stepping shape; and one wherein minute periodic structure is approximated by a triangular wave shape.

Such diffractive optical element can be manufactured through a semiconductor process (lithography, for example) or a cutting process.

Among these diffractive optical elements, a diffractive optical element of stepping shape (binary shape) is called a "binary optics (BO)", and a very fine structure can be manufactured through a semiconductor process such as lithography.

As an example, quartz may be used as a substrate for a binary optics; an i-line stepper may be used for an exposure process (printing a periodic pattern); a parallel flat plate type RIE apparatus may be used for a dry etching process; then, through photolithography, a binary optics of ring-like pattern wherein each ring comprises eight steps (levels) may be produced. However, when a binary optics is manufactured by directly processing a quartz substrate, the quartz substrate may absorb a portion of intense light energy (e.g., laser light from a ArF or KrF excimer laser), causing compaction (contraction) thereof. This results in deformation of the shape of the binary optics.

It is an object of the present diffractive optical element to provide a diffractive optical element which does not cause compaction or large compaction, when it is irradiated with intense light energy.

It is another object of the present invention to provide an optical system having such diffractive optical element.

In accordance with an aspect of the present invention, there is provided a diffractive optical element, as defined in claim 1.

The diffraction grating may consists only of SiO₂.

The diffraction grating may have a multilayered structure comprising SiO₂ and a fluoride compound, or a multilayered structure comprising SiO₂ and a metal oxide.

The diffraction grating may preferably comprise a binary optics.

A layer of SiO₂ in the multilayered structure may serve mainly to provide a grating of stepped shape, and a layer of fluoride compound or metal oxide may serve as a stopper in a process for etching the oxide compound.

The fluoride compound in the multilayered structure, having served as an etching stopper, may comprise at least one of magnesium fluoride, lead fluoride, neodymium fluoride, lithium fluoride, lanthanum fluoride, calcium fluoride, barium fluoride, and aluminum fluoride.

The metal oxide in multilayered structure, having served as an etching stopper, may comprise at least one of aluminum oxide, magnesium oxide, hafnium oxide, neodymium oxide and cerium oxide.

In one preferred form of diffractive optical element, an anti-reflection film is formed on the surface of the substrate on which the diffraction grating is provided. The back surface of the substrate may also be provided with an anti-reflection film.

These and other objects, features and advantages of the present invention will become more apparent upon a consideration of the following description of the preferred examples of a diffractive optical element taken in conjunction with the accompanying drawings.

### BRIEF DESCRIPTION OF THE DRAWINGS

Figure 1 is a schematic view of a main portion of a diffractive optical element according to a first example.
Figures 2A and 2B are sectional views, respectively, of a portion of Figure 1.
Figure 3 is a schematic view for explaining a multilayered film of a diffractive optical element.
Figure 4 is a schematic view for explaining a process for making a diffraction grating in a diffractive optical element.
Figure 5 is a sectional view for explaining a diffractive optical element according to a second example.
Figure 6 is a perspective view of a binary optics according to a third embodiment.
Figure 7 is a sectional view of the binary optics of the Figure 6 example.
Figure 8 is an enlarged view of a portion of the sectional view of Figure 7, showing an example wherein one ring zone is defined by eight steps (levels).
Figure 9 is a schematic and sectional view for explaining a substrate, for the binary optics shown in Figures 6 - 8, prior to formation of a diffraction grating.
Figure 10 is a schematic view for explaining a process of manufacturing the binary optics shown in Figures 6 - 8.
Figure 11 is a schematic view of a diffractive optical element according to a fourth example, wherein an anti-reflection film is formed on a diffraction grating of binary optics such as shown in Figures 6 - 8.
Figure 12 is a schematic view of a projection exposure apparatus.

### DESCRIPTION OF THE PREFERRED EMBODIMENTS

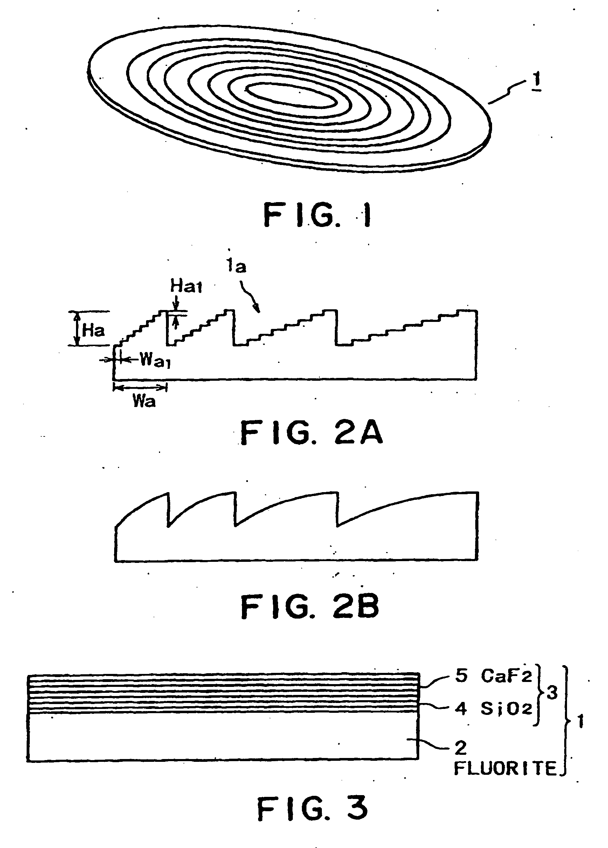

Figure 1 is a schematic view of a main portion of a diffractive optical element. Denoted at 1 in the drawing is a diffractive optical element.

The diffractive optical element 1 comprises a binary optics lens (a lens provided by a binary optics), having a diffraction grating with lens function. But may be applicable also to diffractive optical element which comprises a Fresnel diffraction grating or a teeth-like diffraction grating, for example.

Typically, the sectional shape of the diffraction grating may be a stepped shape (binary shape) such as illustrated in the sectional view of Figure 2A of this embodiment, or a Kinoform shape such as illustrated in the sectional view of Figure 2B. However, the shape is not limited to them.

Figure 3 is a schematic and sectional view of a substrate to be used for manufacturing a diffractive optical element of the first example, that is, in a state prior to making a diffraction grating thereon. The substrate 2 of the diffractive optical element 1 of this embodiment consists of a fluoride compound such as fluorite, for example. Diffraction grating 1a to be provided on the substrate 2 is made of quartz or silica (SiO₂) 4 and a fluoride compound 5 such as fluorite (calcium fluoride), for example. These materials are accumulated into a multilayered film 3 and, by etching the film 3, a diffraction grating such as shown in Figure 2A is provided.

Here, the silica layer 4 serves mainly to provide steps through dry etching, while the fluoride compound layer 5 serves, in the dry etching process for the silica layer 4, as a stopper for controlling the amount of etching.

In this example, in place of conventionally used quartz, use is made of fluorite (fluoride compound) for the substrate of a diffractive optical element. As compared with quartz, fluorite has an advantage of small compaction (contraction). Also, it provides correction of chromatic aberration. Thus, fluorite is a material suitable for a binary optics lens in an imaging optical system. However, as compared with quartz, it has a lower stiffness. Therefore, as compared with quartz, dry etching is not easy.

In this example, in consideration of the above, a thin film of quartz or silica (oxide compound) which can be dry etched easily is provided on the surface of a fluorite (fluoride compound) substrate. Then, by using a photolithography process and a dry etching process, a diffraction grating is defined on such silica thin film.

Silica thin film may be.formed on the basis of sputtering film forming method, EB film forming method, or CVD film forming method, for example. In this example, the sputtering film forming method is used to produce a binary optics, because of its ease in handling.

In this example, in order to meet difficulty in etching control in depth direction which otherwise may cause degraded surface property of the etched surface, seven silica layers of a thickness corresponding to the binary steps may be formed beforehand, and a thin film layer that functions as an etching stopper may be provided at the boundary between the steps (i.e., between silica layers).

As for the material of such thin film, it may be a material having resistivity to an etching gas, for etching the silica, and having a property that, when the etching gas is replaced by another, then the silica shows resistivity. Since generally metal fluoride has a resistivity to halogen series etching gas, it may suitably used as a material for silica film RIE etching stopper. Thus, in this embodiment, fluoride compound, particularly, fluoride compound having good transmissivity to deep ultraviolet rays such as magnesium fluoride, lead fluoride, neodymium fluoride, lithium fluoride, lanthanum fluoride, calcium fluoride, or barium fluoride, for example, may be used as an etching stopper, by which a corresponding fluoride metal film of about 100 angstroms may be formed on the surface of each silica thin film layer. This enables a binary optics lens with fluorite base, having good shape precision and good surface property, under tolerant etching condition.

A specific structure of the diffractive optical element 1 in the first example will be described below.

The diffractive optical element (binary optics lens) 1 of the first example had a circular outside shape with a diameter 20mm Ø. This optical element is adapted for use with light of a wavelength 248 nm from a KrF excimer laser, and thus its design wavelength is 248 nm. The total number of rings of the diffraction grating of this optical element was about 1800. Each ring comprised eight-step shape element (unit) such as shown in Figure 2A.

In the binary optics lens of Figure 2A, in the design value the steps constituting the outermost ring has a width (of each step) Wal of 0.35 micron and a height Hal of 0.062 micron. The width Wa of the ring (i.e., the whole steps) and the height Ha thereof were Wa = 2.8 micron (= 0.35 micron x 8) and Ha = 0.434 micron (= 0.062 micron x 7), respectively.

As for the substrate 2, a crystal substrate of fluorite of a diameter 4 inches (100mm) and a thickness 4 mm was used. By using a sputtering apparatus for multi-sputtering and in accordance with continuous film forming method, silica (SiO₂) 4 of about 520 angstroms and barium fluoride 5 (i.e., metal fluoride) of about 100 angstroms were formed on the substrate. The total film thickness was about 620 angstroms. A pair of one silica layer and one barium fluoride layer provides one step of the eight-step binary optics. The operation was repeated seven times, whereby seven accumulated layers (each comprising a pair) having a thickness of about 0.434 micron, were produced.

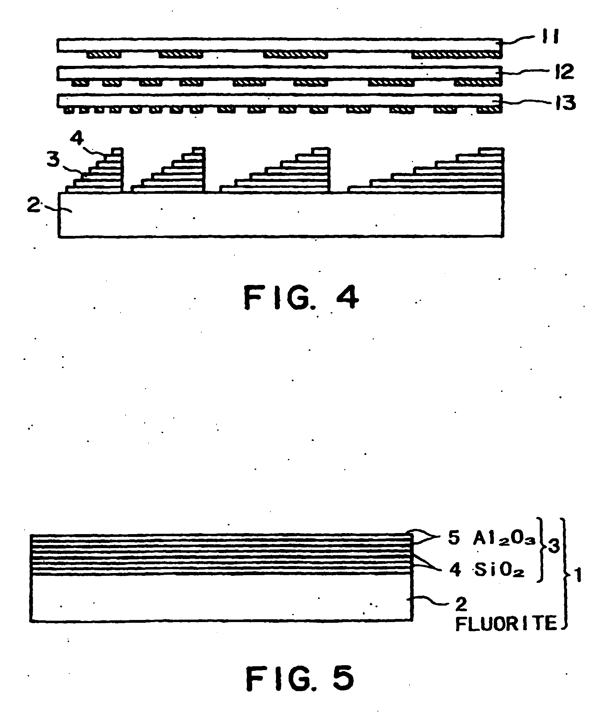

The diffraction grating 1a having eight steps per unit can be produced by using an i-line stepper (λ = 365 nm) on the above-described fluorite substrate with seven-layer multilayered film. More specifically, as shown at the upper half of Figure 4, patterns of chromium masks 11, 12 and 13 are printed sequentially on a photoresist on the binary optics substrate 2, each printing being followed by development of photoresist and dry etching (RIE) process using the developed resist pattern as a mask, whereby the multilayered film 3 on the fluorite substrate 2 can be etched and patterned. Since the fluorite 5 of the substrate 2 has resistivity to a halogen series etching gas, the bottom step does not need an etching stopper film. The lower half of Figure 4 shows that, with the result of repeating the above-described process three times by using the three masks 11, 12 and 13 sequentially, a binary optics lens having a diffraction grating structure with eight-step unit for each ring can be produced on the substrate 2.

A modified form of the first example will be described below.

The diffractive optical element 1 of this modified form had a circular outside shape with a diameter 20mm, like the first example of Figure 1. In place of the barium fluoride of the first example, this modified form used calcium fluoride.

As for the substrate 2, a crystal substrate of fluorite of a diameter 4 inches (100mm) and a thickness 4 mm was used. By using a sputtering apparatus for multi-sputtering and in accordance with continuous film forming method, silica (SiO₂) 4 of about 520 angstroms and calcium fluoride 5 (i.e., metal fluoride) of about 100 angstroms were formed on the substrate. The total film thickness was about 620 angstroms. The operation was repeated seven times, whereby seven accumulated layers having a thickness of about 0.434 micron, were produced.

The binary optics lens 1 can be produced by using an i-line stepper (λ = 365. nm) on the above-described fluorite substrate with seven-layer multilayered film. More specifically, as shown at the upper half of Figure 4, patterns of chromium masks 11, 12 and 13 are printed sequentially on a photoresist on the binary optics substrate 2, each printing being followed by development of photoresist and dry etching (RIE) process using the developed resist pattern as a mask, whereby the multilayered film 3 on the fluorite substrate 2 can be etched and patterned. As an etching gas, a gas mainly containing CCl₂F₂, CF₄ and BCl₃, was used. The above-described process was repeated three times by using the three masks 11, 12 and 13 sequentially, whereby a binary optics lens was produced.

Another modified form of the first example will be described below.

The diffractive optical element 1 of this modified form had a circular outside shape with a diameter 20mm, like the first example. In place of barium fluoride in the first example, this modified form used aluminum fluoride (AlF₃), and seven-layer multilayered film of silica (SiO₂) and aluminum fluoride was formed on a fluorite substrate 2. Like the first example, through a photolithographic process, a binary optics lens was produced.

A further modified form of the first example will be described below.

A diffractive optical element 1 of this modified form comprises, like the first example of Figure 1, a fluorite substrate 2 on which a seven-layer multilayered film of quartz (SiO₂) and fluoride compound (metal fluoride of one of magnesium fluoride, lead fluoride, neodymium fluoride, lithium fluoride, lanthanum fluoride, cryolite, etc.) is formed. Through a photolithographic process similar to the first example, a binary optics lens was produced.

Next, a second example will be described. A diffractive optical element according to the second embodiment is like that shown in Figure 1 of the first example. Also in the second example, the diffractive optical element comprises a binary optics lens having a diffraction grating with lens function. However, the present invention is applicable also to a diffractive optical element having a Fresnel diffraction grating or a teeth-like diffraction grating, for example.

Typically, the sectional shape of the diffraction grating may be a stepped shape (binary shape) such as illustrated in the sectional view of Figure 2A, or a Kinoform shape such as illustrated in the sectional view of Figure 2B. However, the shape is not limited to them.

Figure 5 is a schematic and sectional view of a substrate to be used for manufacturing a diffractive optical element of the second example. The substrate 2 of the diffractive optical element 1 of this embodiment consists of a fluoride compound such as fluorite, for example. Diffraction grating 1a to be provided on the substrate 2 is made of quartz or silica (SiO₂) 4 and a metal oxide 5 such as aluminum oxide (Al₂O₃), for example. These materials are accumulated into a multilayered film 3 and, by etching the film 3, a diffraction grating such as shown in Figure 2A is provided.

Here, the silica layer 4 serves mainly to provide steps through dry etching, while the metal oxide layer 5 serves, in the dry etching process for the silica layer 4, as a stopper for controlling the amount of etching.

In this example, in place of conventionally used quartz, use is made of fluorite (fluoride compound) for the substrate of a diffractive optical element. As compared with quartz, fluorite has an advantage of small compaction (contraction). Also, it provides correction of chromatic aberration. Thus, fluorite is a material suitable for a binary optics lens in an imaging optical system. However, as compared with quartz, it has a lower stiffness. Therefore, as compared with quartz, dry etching is not easy.

In this example, in consideration of the above, a thin film of quartz or silica (silicon oxide) which can be dry etched easily is provided on the surface of a fluorite (fluoride compound) substrate. Then, by using a photolithography process and a dry etching process, a diffraction grating is defined on such silica thin film.

Silica thin film may be formed on the basis of sputtering film forming method, EB film forming method, or CVD film forming method, for example. In this example, the sputtering film forming method is used to produce a binary optics, because of its easiness in handling.

In this embodiment, in order to meet difficulty in etching control in depth direction which otherwise may cause degraded surface property of the etched surface, silica layers of a thickness corresponding to the binary steps may be formed beforehand, and a thin film layer that functions as an etching stopper may be provided at the boundary between the steps (i.e., between silica layers).

As for the material of such thin film, it may be a material having resistivity to an etching gas, for etching the silica, and having a property that, when the etching gas is replaced by another, then the silica shows resistivity. Thus, in this second example, metal oxide, particularly, metal oxide having good transmissivity to deep ultraviolet rays such as aluminum oxide may be used, by which a corresponding aluminum oxide film of about 100 angstroms may be formed on the surface of each thin film layer. This enables a binary optics lens with fluorite base, having good shape precision and good surface property, under tolerant etching condition.

A specific structure of the diffractive optical element 1 in the second example will be described below.

The diffractive optical element (binary optics lens) 1 of the second example had a circular outside shape with a diameter 20mm ø. This optical element is adapted for use with light of a wavelength 248 nm from a KrF excimer laser, and thus its design wavelength is 248 nm. The total number of rings of the diffraction grating of this optical element was about 1800. Each ring comprised eight-step shape element (unit) such as shown in Figure 2A.

In the binary optics lens of Figure 2A, showing binary optics lens element unit 1a, in the design value the steps constituting the outermost ring has a width (of each step) Wal of 0.35 micron and a height Hal of 0.062 micron. The width Wa of the ring (i.e., the whole steps) and the height Ha thereof were Wa = 2.8 micron (= 0.35 micron x 8) and Ha = 0.434 micron (= 0.062 micron x 7), respectively.

As for the substrate 2, a crystal substrate of fluorite of a diameter 4 inches (100mm) and a thickness 4 mm was used. By using a sputtering apparatus for multi-sputtering and in accordance with continuous film forming method, silica (SiO₂) 4 of about 520 angstroms and aluminum oxide (Al₂O₃) (i.e., metal oxide) of about 100 angstroms were formed on the substrate. The total film thickness was about 620 angstroms. A pair of one silica layer and one aluminum oxide layer provides one step of the eight-step binary optics element. The operation was repeated seven times, whereby seven accumulated layers having a thickness of about 0.434 micron, were produced.

The diffraction grating 1a having eight steps per unit can be produced by using an i-line stepper (λ = 365 nm) on the above-described fluorite substrate with seven-layer multilayered film, similarly to the first example. More specifically, as shown in Figure 4, patterns of chromium masks 11, 12 and 13 are printed sequentially on a photoresist on the binary optics substrate 2, each printing being followed by development of photoresist and dry etching (RIE) process using the developed resist pattern as a mask, whereby the multilayered film 3 on the fluorite substrate 2 can be etched and patterned. Since the fluorite 5 of the substrate 2 has resistivity to a halogen series etching gas, the bottom step does not need an etching stopper film.

A modified form of the second example will be described below.

The diffractive optical element 1 of this modified form had a circular outside shape with a diameter 20mm. In place of the aluminum oxide (Al₂O₃) of the second example, this modified form used MgO.

As for the substrate 2, a crystal substrate of fluorite of a diameter 4 inches (100mm) and a thickness 4 mm was used. By using a sputtering apparatus for multi-sputtering and in accordance with continuous film forming method, silica (SiO₂) 4 of about 520 angstroms and magnesium oxide 5 (i.e., metal oxide) of about 100 angstroms were formed on the substrate. The total film thickness was about 620 angstroms. The operation was repeated seven times, whereby seven accumulated layers having a thickness of about 0.434 micron, were produced.

The binary optics lens 1 can be produced by using an i-line stepper (λ = 365 nm), like the second example. More specifically, as shown in Figure 4, patterns of chromium masks 11, 12 and 13 are printed sequentially on a photoresist on the binary optics substrate 2, each printing being followed by development of photoresist and dry etching (RIE) process using the developed resist pattern as a mask, whereby the multilayered film 3 on the fluorite substrate 2 can be etched and patterned. As an etching gas, a gas mainly containing CCl₂F₂ and CF₄ was used. The above-described process was repeated three times by using the three masks 11, 12 and 13 sequentially, whereby a binary optics lens was produced.

Another modified form of the second example will be described below.

The diffractive optical element 1 of this modified form had a circular outside shape with a diameter 20mm. In place of aluminum oxide in the second embodiment, this modified form used neodymiun oxide, and seven-layer multilayered film of silicon oxide (SiO₂) and neodymium oxide was formed on a fluorite substrate 2. Like the second embodiment, through a photolithographic process, a binary optics lens was produced.

A further modified form of the second embodiment will be described below.

A diffractive optical element 1 of this modified form comprises, like the second example, a fluorite substrate 2 on which a seven-layer multilayered film of quartz (SiO₂) and metal oxide of one of hafnium oxide and cerium oxide, for example, is formed. Through a photolithographic process similar to the second example, a binary optics lens was produced.

It is to be noted that, even if the third dry etching process is made slightly excessively, the resistivity as an etching stopper of the barium fluoride substrate 2 is effective to assure good finishing with good precision.

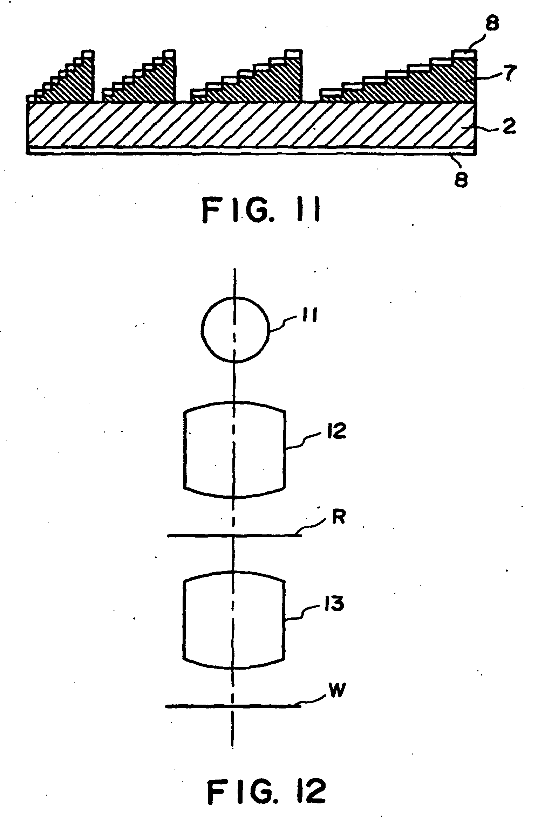

Figure 11 is a sectional view of a diffractive optical element according to another preferred form. In this example, like the preceding example, a thin film 3 of silica is formed on a fluorite substrate 2, and, through a similar photolithographic process and a similar dry etching process, a binary optics lens of eight-step structure is produced. After this, anti-reflection coatings 8 are formed on opposite surfaces of the binary optics lens. The anti-reflection film 8 was provided by a layer of lithium fluoride (LiF) deposited by 62 nm through RF sputtering method, for example. Diffraction efficiency of the resultant binary optics lens was measured by using KrF laser, and the result is that, as compared with an element without anti-reflection film on opposite surfaces, the diffraction efficiency was improved by about 12%.

In another preferred form corresponding to a modified form of the preceding example, magnesium fluoride and alumina (Al₂O₃) were deposited by RF sputtering method, each with a thickness 62 nm, whereby an anti-reflection coating 8 was formed. With this anti-reflection film 8, the diffraction efficiency was improved by about 16% as compared with the element without anti-reflection film on opposite surfaces thereof.

It is to be noted that use of such anti-reflection coating is effective in any of the first and second embodiments and in any of modified forms described above. Such anti-reflection coating may be provided on only one surface of the substrate, if desired.

Figure 12 is a schematic view of an optical arrangement of a projection exposure apparatus. There are, in an order from the above, a light source 11 such as a lamp or laser, an illumination optical system 12 for providing uniform illumination by use of light from the light source 11, a reticle R to be illuminated with the illumination optical system 12, a projection optical system 13 for projecting a pattern formed on the reticle R onto a wafer W, and the wafer W on which the pattern is to be projected by the projection optical system 13.

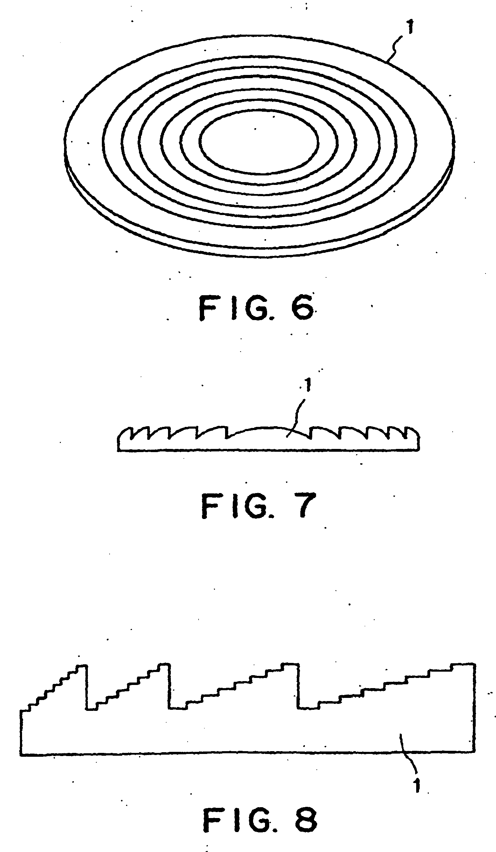

A third example will be described with reference to Figures 6 - 11.

Figure 6 is a perspective view of a binary optics lens having ring-like diffraction elements (steps). Figure 7 is a sectional view of the binary optics lens, and Figure 8 is an enlarged view of a portion of Figure 7. As designed, the binary optics lens is to be used with KrF laser light of used wavelength 248 nm, and it has rings as diffraction element unit of a number of about 1800. Each ring has eight steps (levels) such as shown in Figure 8, and the whole structure provides a binary optics lens 1 of circular shape, with a diameter 20 mm. In the design value, the steps constituting the outermost ring each has a width Wal of 0.35 micron and a height Ha1 of 0.062 micron. The width of ring as the unit of diffraction element is 2.8 microns, and the height is 0.434 micron.

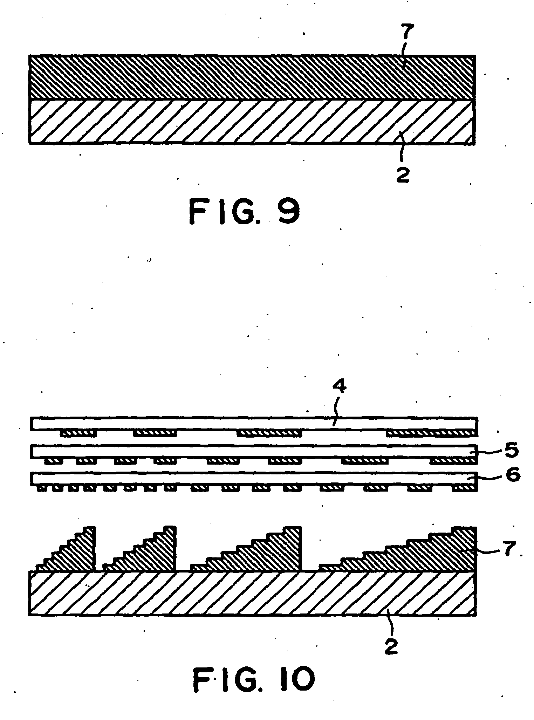

Figure 9 is a sectional view of a substrate, prior to production of binary optics lens of the third embodiment. In this embodiment, a crystal plate of fluorite (CaF₂) of a diameter 100 mm and a thickness 4mm is used. By using a sputtering apparatus, a thin film 7 of silica (SiO₂) which can be dry etched easily is formed on the surface of the fluorite substrate 2, to a thickness of about 0.434 micron, corresponding to the level difference of the binary optics. In place of sputtering film forming method, EB film forming method or CVD film forming method may be used.

Figure 10 is a sectional view of chromium masks to be used for forming eight fine steps on the silica thin film 3 of the substrate of the binary optics lens, as well as of the binary optics lens to be produced thereby. An i-line stepper (exposure wavelength λ = 365 nm) which is a photolithographic reduction exposure printing apparatus is used to print a pattern of the chromium mask 4 on a photoresist of the substrate 2 in reduced scale, and the exposed substrate is developed, whereby a resist pattern is defined. Dry etching process is then performed while the resist pattern is used as a mask, whereby the thin film 3 of the substrate 2 is etched and patterned, such that steps are defined thereon. Subsequently, while using the chromium masks 5 and 6, the above-described procedure is repeated, whereby steps (7) are produced in the thin film 7 and a binary optics lens 1 is produced.

Fluoride compound as represented by fluorite generally has resistivity to a dry etching gas such as halogen gas, for example, and thus it functions as an etching stopper. Therefore, a high precision binary optics lens for which substantially vertical steps are required, can be produced.

In a modified form of the third embodiment, in place of the fluorite substrate 2, a crystal plate 2 of barium fluoride of a diameter 100 mm and a thickness 4 mm, may be used. By using an RF sputtering apparatus, a silica thin film 7 may be formed on the substrate 2 with a thickness of about 0.43 micron, whereby a binary optics lens 1 of circular shape having a diameter 20 mm, can be produced.

Also in that occasion, an i-line stepper is used to print a pattern of a chromium mask on a photoresist of the substrate 2 of barium fluoride with silica thin film, in reduced scale, and the exposed substrate is developed, whereby a resist pattern is defined. Dry etching process is then performed while the resist pattern is used as a mask, whereby the thin film 3 of the barium fluoride substrate 2 is etched and patterned and a binary optics lens is produced. As an etching gas, a gas mainly consisting of CF₄/H₂ and CH₂F₂ is used, and the above-described process is repeated three times by using three masks 4 and 5, whereby a binary optics lens 1 is provided.

As regards the shape of the substrate 2 in the binary optics lenses having been described above, the substrate may have flat surfaces on opposite sides, a flat surface on one side only, or curved surfaces on opposite sides.

Referring back to Figure 12, a binary optics lens to be used in this exposure apparatus may be any one of the binary optics lenses having been described above. Through divided exposures by use of a stepper, a size of 200 mm diameter can be produced. Such a binary optics lens may be incorporated into the illumination optical system 12 or the projection optical system 13. With reduction printing of a silicone substrate through a KrF laser stepper of step-and-scan type or step-and-repeat type, and in accordance with sequential semiconductor manufacturing processes, high performance semiconductor devices can be produced.

Thus, use of such exposure apparatus enables production of good precision devices such as semiconductor devices (e.g., IC or LSI), liquid crystal devices, image pickup devices (e.g., CCD), magnetic devices (e.g., magnetic head), or optical elements (e.g., BOE).

## Claims

1. A diffractive optical element (1) for use in an illumination optical system (12) or a projection optical system (13) of an exposure apparatus comprising an ArF or KrF excimer laser (11), the illumination optical system (12) being adapted to illuminate a reticle (R) with light from the excimer laser (11), and the projection optical system (13) being adapted to project a pattern formed on the reticle onto a wafer (W), **characterised in that**
said diffractive optical element (1) comprises:
a substrate (2) made of CaF₂; and
a diffraction grating (1a) formed on the substrate and comprising SiO₂.

2. A diffractive optical element according to any preceding claim, wherein the optical element has an anti-reflection film formed on at least one surface thereof.

3. A diffractive optical element according to any preceding claim, wherein the optical element has an anti-reflection film formed on opposing surfaces thereof.

4. A diffractive optical element according to Claim 1, wherein said diffractive optical element comprises a binary optics.

5. A diffractive optical element according to Claim 1, wherein at least one surface of the substrate is flat.

6. A diffractive optical element according to Claim 1, wherein the substrate has a curved surface.

7. An optical system having a diffractive optical element according to any one of Claims 1 to 6.

8. An exposure apparatus including an optical system according to Claim 7.

9. A device manufacturing method for transferring a device pattern onto a wafer by use of an exposure apparatus according to claim 8.

10. A method of producing a diffractive optical element for use in an illumination optical system (12) or a projection optical system (13) of an exposure apparatus comprising an ArF or KrF excimer laser (11), the illumination optical system (12) being adapted to illuminate a reticle (R) with light from the excimer laser (11), and the projection optical system (13) being adapted to project a pattern formed on the reticle onto a wafer (W), the method comprising the steps of:
providing a substrate of CaF₂;
providing a layer comprising SiO₂ on the substrate; and
forming a diffractive optical pattern by an etching process in the layer comprising SiO₂.

11. A method according to claim 10, further comprising the step of forming an anti-reflection layer on one or both surfaces of the optical element.

## Patentansprüche

1. Optisches Beugungselement (1) zur Verwendung in einem optischen Beleuchtungssystem (12) oder einem optischen Projektionssystem (13) einem Belichtungsgerät mit einem ArF- oder KrF-Excimerlaser (11), wobei das optische Beleuchtungssystem (12) angepasst ist, eine Maske (R) mit einem Licht von dem Excimerlaser (11) zu beleuchten, und das optische Projektionssystem (13) angepasst ist, ein auf der Maske ausgebildetes Muster auf einen Wafer (W) zu projizieren, **dadurch gekennzeichnet, dass**
das optische Beugungselement (1) aufweist:
ein Substrat (2), das aus CaF₂ hergestellt ist; und
ein Beugungsgitter (1a), das auf dem Substrat ausgebildet ist und SiO₂ aufweist.

2. Optisches Beugungselement gemäß einem vorhergehenden Anspruch, wobei das optische Element einen Antireflexionsfilm hat, der an zumindest einer Oberfläche von ihm ausgebildet ist.

3. Optisches Beugungselement gemäß einem vorhergehenden Anspruch, wobei das optische Element einen Antireflexionsfilm hat, der an einer entgegengesetzten Oberfläche von ihm ausgebildet ist.

4. Optisches Beugungselement gemäß Anspruch 1, wobei das optische Beugungselement eine Binäroptik aufweist.

5. Optisches Beugungselement gemäß Anspruch 1, wobei zumindest eine Oberfläche des Substrats flach ist.

6. Optisches Beugungselement gemäß Anspruch 1, wobei das Substrat eine gekrümmte Oberfläche hat.

7. Optisches System mit einem optischen Beugungselement gemäß einem der Ansprüche 1 bis 6.

8. Belichtungsgerät mit einem optischen System gemäß Anspruch 7 umfasst.

9. Vorrichtungsherstellungsverfahren zum Übertragen eines Vorrichtungsmusters auf einen Wafer unter Verwendung eines Belichtungsgeräts gemäß Anspruch 8.

10. Verfahren zum Herstellen eines optischen Beugungselements zur Verwendung in einem optischen Beleuchtungssystem (12) oder einem optischen Projektionssystem (13) einem Belichtungsgerät mit einem ArF- oder KrF-Excimerlaser (11), wobei das optische Beleuchtungssystem (12) angepasst ist, eine Maske (R) mit einem Licht von dem Excimerlaser (11) zu beleuchten, und das optische Projektionssystem (13) angepasst ist, ein auf der Maske ausgebildetes Muster auf einen Wafer (W) zu projizieren, wobei das Verfahren die Schritte aufweist:
Vorsehen eines Substrats aus CaF₂;
Vorsehen einer aus SiO₂ hergestellten Lage auf dem Substrat; und
Ausbilden eines optischen Beugungsmusters in der SiO₂ aufweisenden Lage durch einen Ätzprozess.

11. Verfahren gemäß Anspruch 10, das des weiteren den folgenden Schritt aufweist: Ausbilden einer Antireflexionslage an einer oder beiden Oberflächen des optischen Elements.

## Revendications

1. Elément optique de diffraction (1) destiné à être utilisé dans un système optique (12) d'illumination ou dans un système optique (13) de projection d'un appareil d'exposition comportant un laser (11) à excimère ArF ou KrF, le système optique d'illumination (12) étant conçu pour illuminer un réticule (R) avec de la lumière provenant du laser à excimère (11), et le système optique de projection (13) étant conçu pour projeter sur une plaquette (W) un motif formé sur le réticule, **caractérisé en ce que**
ledit élément optique de diffraction (1) comporte:
un substrat (2) réalisé en CaF₂ ; et
un réseau de diffraction (1a) formé sur le substrat et comprenant du SiO₂.

2. Elément optique de diffraction selon la revendication précédente, lequel élément optique comporte un film antiréfléchissant formé sur au moins l'une de ses surfaces.

3. Elément optique de diffraction selon l'une des revendications précédentes, lequel élément optique comporte un film antiréfléchissant formé sur ses surfaces opposées.

4. Elément optique de diffraction selon la revendication 1, lequel élément optique de diffraction comprend une optique binaire.

5. Elément optique de diffraction selon la revendication 1, dans lequel au moins une surface du substrat est plate.

6. Elément optique de diffraction selon la revendication 1, dans lequel le substrat a une surface courbe.

7. Système optique comportant un élément optique de diffraction selon l'une quelconque des revendications 1 à 6.

8. Appareil d'exposition comprenant un système optique selon la revendication 7.

9. Procédé de fabrication de dispositif pour transférer un motif de dispositif sur une plaquette en utilisant un appareil d'exposition selon la revendication 8.

10. Procédé de production d'un élément optique de diffraction destiné à être utilisé dans un système optique d'illumination (12) ou un système optique de projection (13) d'un appareil d'exposition comprenant un laser à excimère ArF ou KrF (11), le système optique d'illumination (12) étant conçu pour illuminer un réticule (R) avec de la lumière provenant du laser à excimère (11), et le système optique de projection (13) étant conçu pour projeter sur une plaquette (W) un motif formé sur le réticule, le procédé comprenant les étapes qui consistent :
à utiliser un substrat en CaF₂ ;
à appliquer une couche constituée de SiO₂ sur le substrat ; et
à former un motif optique de diffraction par un processus d'attaque dans la couche comprenant du SiO₂.

11. Procédé selon la revendication 10, comprenant en outre l'étape de formation d'une couche antiréfléchissante sur une surface ou sur les deux surfaces de l'élément optique.
